# EUROPEAN PATENT SPECIFICATION

(11) **EP 0 956 741 B1**
(45) Date of publication and mention of the grant of the patent: **09.03.2005**
(21) Application number: 97952655.5
(22) Date of filing: 23.12.1997
(51) Int. Cl.: H05B 33/14, H01L 51/20

(54) **LIGHT EMITTING ARTICLES WITH LIGHT REFLECTING STRUCTURES**
LICHTEMITTIERENDE GEGENSTÄNDE MIT LICHTREFLEKTIERENDE STUKTUREN
ARTICLES LUMINESCENTS PRESENTANT DES STRUCTURES REFLECHISSANT LA LUMIERE

(30) Priority: 23.12.1996 US 774119; 23.12.1996 US 772332; 03.02.1997 US 794595; 18.04.1997 US 844353
(43) Date of publication of application: 17.11.1999
(73) Proprietor: THE TRUSTEES OF PRINCETON UNIVERSITY, Princeton, NJ 08544-0636 (US)
(72) Inventor: BULOVIC, Vladimir, Metuchen, NJ 08840 (US); FORREST, Stephen, R., Princeton, NJ 08540 (US); BURROWS, Paul, Princeton Junction, NJ 08550 (US); GARBUZOV, Dmitri, Z., Princeton, NJ 08540 (US)
(74) Representative: Meyer-Dulheuer, Karl-Hermann, Dr.
(86) International application number: PCT/US1997/023947
(87) International publication number: WO 1998/028947

(56) References cited:
- US-A- 5 294 870
- US-A- 5 663 573
- US-A- 5 674 597
- PATENT ABSTRACTS OF JAPAN vol. 1996, no. 09, 30 September 1996 (1996-09-30) & JP 08 138870 A (IDEMITSU KOSAN CO LTD), 31 May 1996 (1996-05-31)

## Description

### Field Of The Invention

This invention relates to organic light emitting devices (OLED's), and more particularly to light emitting articles, that are designed to maximize efficiency and minimize losses due to waveguiding.

### Background Of The Invention

The electronic display is used in such devices as television sets, computer terminals, telecommunications equipment and a host of other applications. Among the types of electronic displays currently available, flat panel display technology is of significant interest and progress is continuously being made in this field. Desirable factors for any display technology include the ability to provide a high resolution, full color display at good light level and at competitive pricing.

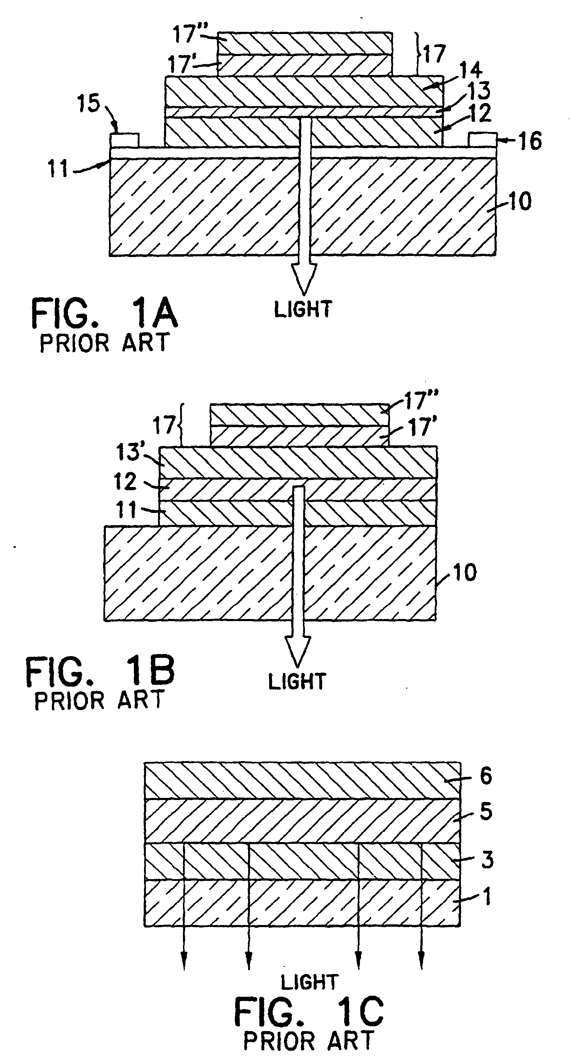

Organic light emitting devices (OLED's), which make use of thin film materials which emit light when excited by electric current, are becoming an increasingly popular form of flat panel display technology. Presently, the most favored organic emissive structure is referred to as the double heterostructure (DH) OLED, shown in Fig. 1A. In this device, a substrate layer of glass 10 is coated by a thin layer of indium-tin-oxide (ITO) 11. Next, a thin (100-500 Å) organic hole transporting layer (HTL) 12 is deposited on ITO layer 11. Deposited on the surface of HTL 12 is a thin (typically, 50Å - 500Å) emission layer (EL) 13. The EL 13 provides the recombination site for electrons injected from a 100-500Å thick electron transporting layer 14 (ETL) with holes from the HTL 12. Examples of prior art ETL, EL and HTL materials are disclosed in U.S. Patent No. 5,294,870.

Often, the EL 13 is doped with a highly fluorescent dye to tune color and increase the electroluminescent efficiency of the OLED. The device as shown in Fig. 1A is completed by depositing metal contacts 15, 16 and top electrode 17. Contacts 15 and 16 are typically fabricated from indium or Ti/Pt/Au. Electrode 17 is often a dual layer structure consisting of an alloy such as Mg/Ag 17' directly contacting the organic ETL 14, and a thick, high work function metal layer 17" such as gold (Au) or silver (Ag) on the Mg/Ag. The thick metal 17" is opaque. When proper bias voltage is applied between top electrode 17 and contacts 15 and 16, light emission occurs from emissive layer 13 through the glass substrate 10. An LED device of Fig. 1A typically has luminescent external quantum efficiencies of 0.05% to 2%, depending upon the color of emission and the device structure.

Another known organic emissive structure is referred to as a single heterostructure (SH) OLED, as shown in Fig. 1B. The difference between this structure and the DH structure is that multifunctional layer 13' serves as both EL and ETL. One limitation of the device of Fig. 1B is that the multifunctional layer 13' must have good electron transport capability. Otherwise, separate EL and ETL layers should be included as shown for the device of Fig. 1A.

Yet another known LED device is shown in Fig. 1C, illustrating a typical cross sectional view of a single layer (polymer) OLED. As shown, the device includes a glass substrate 1 coated by a thin ITO layer 3. A thin organic layer 5 of spin-coated polymer, for example, is formed over ITO layer 3, and provides all of the functions of the HTL, ETL, and EL layers of the previously described devices. A metal electrode layer 6 is formed over organic layer 5. The metal is typically Mg, Ca, or other conventionally used low work function metal.

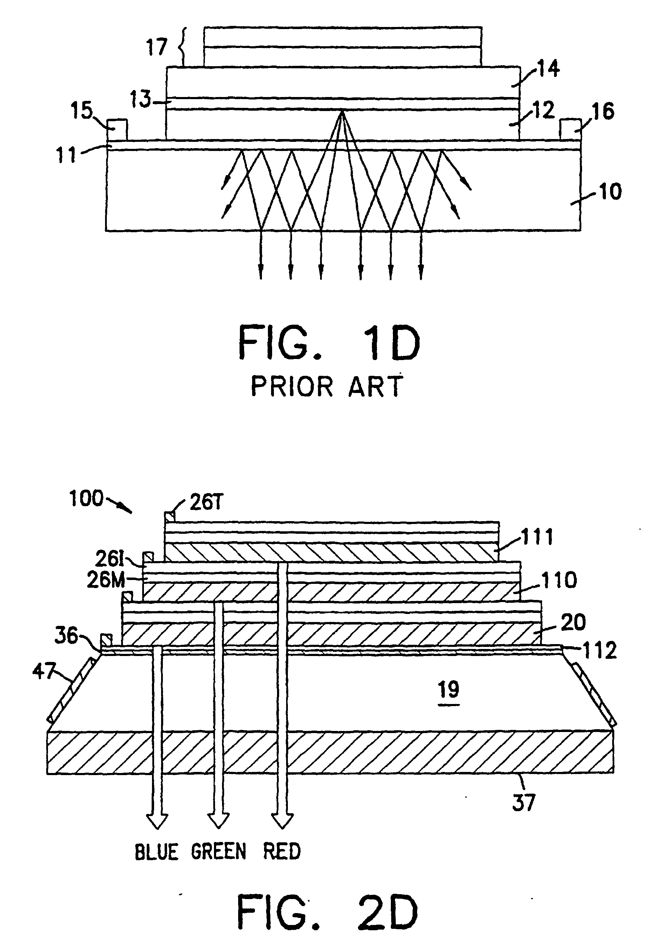

An example of a multicolor electroluminescent image display device employing organic compounds for light emitting pixels is disclosed in U.S. Patent No. 5,294,870. This patent discloses a plurality of light emitting pixels which contain an organic medium for emitting blue light. Fluorescent media are positioned between the blue OLED and the substrate in certain parts of the pixels. The fluorescent media absorb light emitted by'the blue OLED and emit red and green light in different regions of the same pixel. One drawback of this display is that waveguiding of light through the glass substrate from one pixel to adjacent pixels can result in blurring, color bleeding, lack of image resolution and the loss of waveguided light. This problem is schematically shown in Fig. 1D for a device shown in Fig. 1A, and is further described in D.Z. Garbuzov et al., "Photoluminescence Efficiency and Absorption of Aluminum Tri-Quinolate (Alq₃) Thin Films," 249 Chemical Physics Letters 433 (1996). A further problem in this device is that the ITO used as a transparent, conductive layer is a high-loss material, thus resulting in absorption of waveguided light by ITO layers. One additional problem encountered in this and other prior art devices is that the LED interconnect lines can be seen by the viewer as black lines surrounding individual pixels, thus increasing the granularity of the display and limiting resolution.

Japanese patent application No 06274645 (publication No. 08138870 of May 31, 1996) discloses a side-emitting device with the following constitution:

An organic thin film EL element composed by layering a transparent electrode, an organic electroluminescent layer, a specular electrode and a protective layer is formed on one main face of a transparent glass substrate of which three side faces among four side faces are vertical to the main surface and the remaining one face is a tilting side face to the main surface. The substrate and the element except the side face of the substrate and the side face of the element are covered with a reflecting means. The reflecting means is composed of a metal reflecting mirror which covers the main surface in the side of the substrate on which the element is not formed and a white diffusion plate which covers the three side faces except the side face of the substrate and thus the light rays emitted form the element is made to be emitted outside from the part which is not covered with the reflecting means.

The purpose of this invention is to provide a specular electrode of an organic thin film EL element not observed as specular when electroluminescence is not emitted by emitting light rays which are emitted from the organic thin film EL element from a part, which is not covered with a reflecting means, among side parts of the organic thin film EL element.

### Summary Of The Invention

The present invention includes monochromatic and multicolor light emitting articles which make use of light reflecting structures for increased efficiency and decreased losses that are due to waveguiding of otherwise useful light emission. Each of the embodiments of the present invention comprise a substrate, a light reflecting structure positioned in or on the substrate, and an OLED positioned in or on the light reflecting structure. The light reflecting structure is characterized by a top portion and a bottom portion wherein the top portion is narrower than the bottom portion such that light emitted from the OLED is directed towards the bottom portion.

In one aspect, the light emitting articles of the present invention comprise a plurality of pixels, each having at least one light reflecting structure in the form of an angle-walled mesa. The mesas used in the present invention are in the form of truncated pyramids, each having a top portion which is narrower than its bottom portion such that light is directed via reflection off of its side walls and in a direction from its top portion to its bottom portion.

In another aspect, the light emitting articles of the present invention are configured to concentrate light emission. Such articles each comprise a transparent substrate, a light reflecting layer on the substrate, a light reflecting structure in the form of a waveguiding layer on the light reflecting layer, and at least one OLED on the waveguiding layer. The light reflecting layer has at least one opening therein. The light emitted from the OLED(s) is reflected off of the light reflecting structure side walls and the light reflecting layer, such that it is directed through the opening in the light reflecting layer for emission through the substrate.

In a first embodiment, the light emitting article of the present invention includes multiple pixels, each of which comprises light-emitting devices arranged in three mesas on a transparent substrate, wherein the first of said mesas serves as a blue light emitter, the second of said three mesas serves as a green light emitter and the third of said three mesas serves as a red light emitter. In this embodiment, the bottom portion of each mesa is immediately adjacent to the substrate such that the light emitted by each mesa is directed towards the substrate.

In a second embodiment, the light emitting article of the present invention includes multiple pixels, each of which comprises light-emitting devices arranged in three inverted angle-walled mesas wherein the first of said three inverted mesas serves as a blue light emitter, the second of said three inverted mesas serves as a green light emitter and the third of said three inverted mesas serves as a red light emitter. In this embodiment, the mesas are referred to as being "inverted" because the top portion of each mesa is immediately adjacent the substrate such that the light emitted by each mesa is directed away from the substrate. The inverted mesas are positioned either on the substrate or within the substrate.

In a third embodiment, the light emitting article of the present invention includes multiple pixels, each of which comprises light-emitting devices arranged in a single mesa or inverted mesa which serves as an emitter of blue, green or red light, alone or in combination, by virtue of a stacked structure of blue, green and blue OLED's.

In a fourth embodiment, the light emitting article of the present invention comprises a transparent substrate, a light reflecting layer on the substrate, a light reflecting structure in the form of a waveguiding layer on the light reflecting layer, and at least one OLED on the waveguiding layer of the invention. The waveguiding layer has a top surface, a bottom surface, and at least three sides, with one of the sides being at an angle of less than 90° with respect to the substrate and the remainder of the sides being perpendicular to the substrate. The light emitted from the OLED(s) is reflected off of the light reflecting layer and the sides of the waveguiding layer. The emitted light is therefore concentrated and directed through an opening in the light reflecting layer for emission through the substrate.

In a fifth embodiment, the waveguiding layer of the fourth embodiment has at least two sides being at an angle of less than 90° with respect to the substrate and the remainder of the sides being perpendicular to the substrate. The light reflecting layer has multiple openings which are positioned below the sides of the waveguiding layer which are at an angle of less than 90° with respect to the substrate. Light emitted from the OLED(*s*) is thus reflected off of the light reflecting layer and the sides of the waveguiding layer. The emitted light is therefore concentrated and directed through the openings in the light reflecting layer for emission through the substrate and convergence to a common focal point.

### Brief Descrintion Of The Drawings

Fig. 1A is a cross sectional view of a typical organic double heterostructure light emitting device (OLED) according to the prior art.
Fig. 1B is a cross sectional view of a typical organic single heterostructure light emitting device (LED) according to the prior art.
Fig. 1C is a cross sectional view of a known single layer polymer LED structure according to the prior art.
Fig. 1D illustrates the problem of waveguiding in conventional structures LED structures.
Figs. 2A, 2B and 2C are cross sectional views of integrated three color pixels utilizing blue organic light emitting devices (OLED's) and red and green downconversion phosphor layers according to embodiments of this invention.
Fig. 2D illustrates a stacked arrangement of blue, green and red OLED's in a mesa pixel configuration according to an embodiment of the present invention.
Fig. 3 shows a top view of one embodiment of the present invention.
Figs. 4A to 4D illustrate the method of making a first embodiment of the present invention as shown in Fig. 2A.
Figs. 5A to 5E illustrate the method of making a second embodiment of the present invention as shown in Fig. 2B.
Figs. 6A to 6D illustrate the method of making a third embodiment of the present invention as shown in Fig. 2D.
Figs. 7A and 7B are cross-sectional view and top view, respectively, of an embodiment of the present invention.
Fig. 7C is a cross-sectional view of an inverted version of the device shown in Fig. 7A.
Figs. 8A and 8B are cross-sectional view and top view, respectively, of an embodiment of the present invention.
Fig. 9 schematically illustrates *θ>θ*_{c}*,* the critical angle for internal reflection.
Figs. 10A-10C illustrate some OLED variations which can be used in accordance with the present invention.
Figs. 11A-11B graphically illustrate the effects of light emitting device length on emitted light intensity and device efficiency, respectively.

### Detailed Description

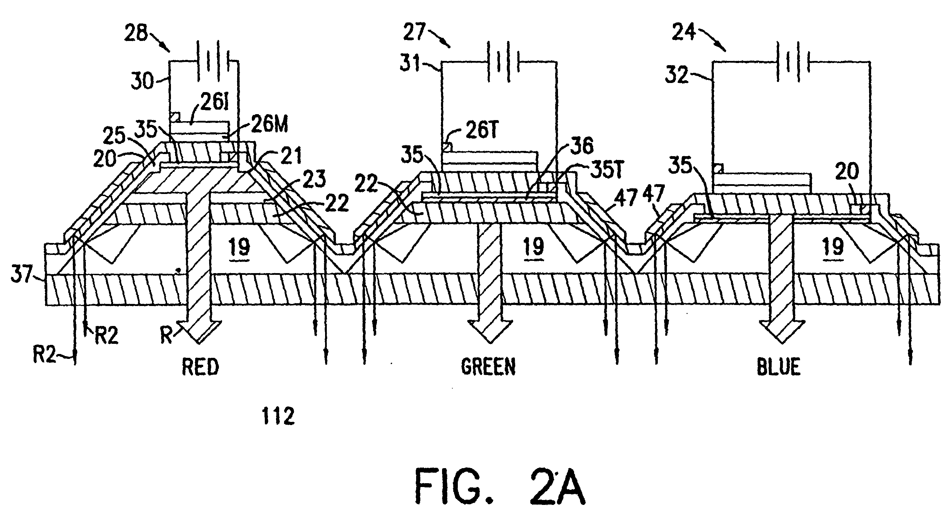

The first embodiment of the present invention is shown in Fig. 2A. In this embodiment, waveguiding is reduced and radiation output is increased due to the collimating effect of the light reflecting structures, which are in the form of mesa structures. This collimation is achieved either by total reflection from the angled walls of the mesa structure or by mirror reflection from metal deposited on the angled walls.

The device shown in Fig. 2A includes pixels having three mesa stacks on a common substrate 37, wherein the stacks comprise a blue OLED layer 20 and red and/or green downconversion phosphors, designated as 21 and 22, respectively, depending upon the particular stack. Substrate 37 is generally fabricated from a transparent material such as glass, quartz, sapphire or plastic. The OLED layer is of either DH or SH configuration, or a single layer of polymer-based OLED, as is well-known in the art.

Device 24 is a blue emitter that includes a blue OLED 20 that extends horizontally to also form a top portion of each of devices' 27 and 28. Device 27 is a green emitter that includes the blue OLED 20 and a green downconversion phosphor 22 in a bottom portion of the stack, with the phosphor 22 converting the blue light from OLED 20 to green light. The third device 28 contains a red downconversion phosphor 21 disposed between the blue OLED 20 and the green downconversion phosphor 22 that converts the blue light from OLED 20 to red light. In this case, the red light passes unabsorbed through green phosphor 22, which is transparent to red light. The green downconversion phosphor 22 is left in device 28 for ease of fabrication. Alternatively, the third device 28 includes the blue OLED 20 and a red downconversion phosphor 21 in a bottom portion of the stack, with the red phosphor converting the blue light from OLED 20 to red light without passing through a green downconversion phosphor layer. In yet another alternative arrangement of the third device 28, a layer of green downconversion phosphor is positioned between blue OLED 20 and red downconversion phosphor 21. In this arrangement, the green downconversion phosphor 22 will convert the blue light emitted from OLED 20 to green light, and then red downconversion phosphor 21 converts this green light to red light. This arrangement, however, is not generally preferred because device efficiency tends to decrease with an increased number of downconversion steps. Although the embodiment shown in Fig. 2A makes use of downconversion phosphor layers, the devices 24, 27 and 28 may instead make use of blue, green and red OLEDs without the use of downconversion phosphor layers.

The mesa walls of any of devices 24, 27 and 28 can be configured at any acute angle so as to minimize or prevent waveguiding, although approximately 35°-45° relative to the substrate is preferred. The collimating dielectric layer 19 making up the bottom-most portion of devices 24, 27 and 28 is angled so that the light that would normally be waveguided into lateral pixels, and contribute to color bleeding and loss of resolution and brightness, is instead directed out of the substrate 37 by reflection off of the mesa side walls and optional reflectors 47. This reflection is shown as beams R₂ which emerge from the dielectric layer 19 through the substrate 37 and act to augment beam R.

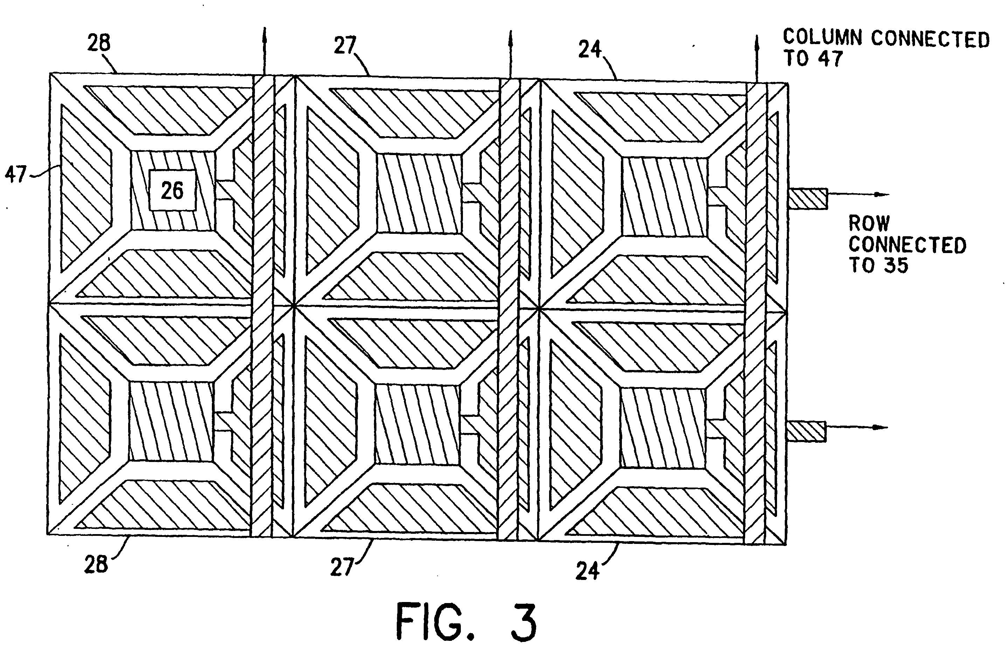

Optional reflectors 47 are made of materials such as, for example aluminum, silver, Mg/Al or any other suitable material. In addition to serving as reflectors, reflectors 47 can be used as interconnects by extending reflectors 47 to connect with metal layers 26 as shown in Fig. 3. One distinct advantage to using reflectors 47 as interconnects is that such interconnects are positioned between adjoining mesas such that they are hidden from the viewer. The resulting display therefore has none of the dark lines between adjoining pixels as are frequently found in conventional display devices.

For simplicity, the OLED devices used in the present invention are shown as single layers in the drawings. As is well-known in the art and described herein, however, these layers actually comprises multiple sub-layers if the OLED is not a single-layer polymer, the arrangement of which sub-layers depends on whether the device is DH or SH configuration.

If, for example, a DH OLED is used in the present invention, OLED device 20 will consist of an HTL vacuum-deposited or grown on or otherwise deposited onto the surface of an ITO layer. A top ETL sandwiches an EL between the former and the HTL. Each of the HTL, ETL, ITO and organic EL layers are transparent because of their composition and minimal thickness. Each HTL may be 50-1000Å thick; each EL may be 50-500Å thick; each ETL may be 50-1000Å thick; and the ITO layer may be 1000-4000Å thick. For optimum performance and low voltage operation, each of the organic layers should preferably be kept towards the lower ends of the above ranges. Each device 24, 27 and 28 (excluding ITO/metal layers) is preferably close to 500Å thick. Examples of suitable organic ETL, EL and HTL materials can be found in U.S. Patent No. 5,294,870.

Formed on top of ETL is a low work function (preferably, <4 eV) metal layer 26M. Suitable candidates for metal layer 26M include Mg, Mg/Ag, and Li/Al. Deposited on the top of metal layer 26M is another conductive layer 26I suitable for forming an electrical contact. Conductive layer 26I can be made of ITO, Al, Ag or Au, for example. For convenience, the double layer structure of metallic layers 26M and 26I is referred to as metal layer 26. Terminal 26T is formed on metal layer 26 for electrical connection thereto, and may be made from In, Pt, Au, Ag, and combinations thereof, or any suitable material as is known in the art.

If a SH OLED structure is used for providing devices 24, 27 and 28, rather than DH OLED devices, the ETL and EL layers are provided by a single multifunctional layer, such as layer 13', as previously described for the SH of Fig. 1B. This layer 13' is Al-quinolate or other known materials which can accomplish the multifunctional purpose of layer 13'. However, an advantage of DH OLED stacks over SH OLED stacks is that DH OLED stacks generally permit higher efficiencies.

The voltages across the OLED's in each of devices 24, 27 and 28 are controlled to provide a desired resultant emission color and brightness for the particular pixel at any instant of time. Obviously, device 24 emits blue light, device 27 emits green light and device 28 emits red light. Moreover, different combinations of devices 24, 27 and 28 can be activated to selectively obtain a desired color of light for the respective pixel partly dependent upon the magnitude of current in each of the devices 24, 27 and 28.

Devices 24, 27 and 28 can be forward biased by batteries 32, 31 and 30, respectively. In Fig. 2A, current flows from the positive terminal of each battery 32, 31 and 30, into the cathode terminal 26T of its associated device, through the layers of each respective device, and from anode terminals 35T formed on conductive layers 35 to negative terminals of each battery 32, 31, and 30. As a result, light is emitted from the OLED layer in each of the devices 24, 27 and 28. Isolation layer 25 prevents the cathode and anode layers from shorting. When the pixels are aggregated into a display, anode and cathode terminals are brought out at an edge of the display, for example.

Each device 24, 27 and 28 optionally comprises a layer 36 of low-loss, high refractive index dielectric material, such as TiO₂, between contact 35 and layer 21, 22 and 19, respectively. Layer 36 is especially preferred when contact 35 is made from ITO, which is a high-loss material such that light from blue OLED layer 20 can be easily waveguided in and absorbed by contact 35. The refractive indexes for TaO₂ and ITO are approximately 2.6 . and 2.2, respectively. Layer 36 therefore substantially eliminates waveguiding and absorption in the ITO, the light emitted from blue OLED layer 20 now being either transmitted through layer 36 or waveguided within layer 36 and reflected by the mesa side walls and reflectors 47. Similar layers to enhance performance, such as hole injection enhancement layers, are optionally included in the devices 24, 27 and 28 as intermediate layers.

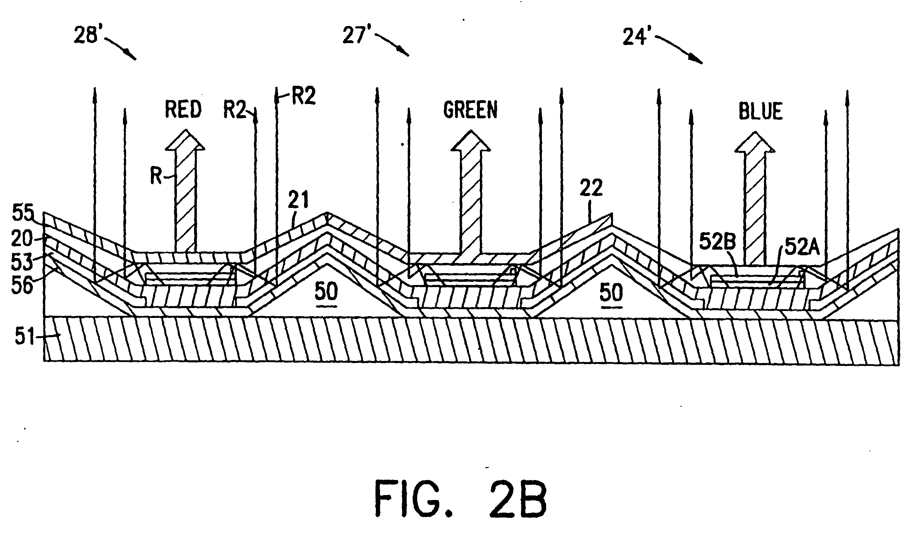

In a second embodiment of the present invention, the device of Fig. 2A is constructed in an opposite or inverted manner, for providing light emission out of the top of the stack rather than the bottom. In accordance with this second embodiment, as shown in Fig. 2B (not drawn to scale), the collimating action of the "inverted" angle-walled mesa structure suppresses waveguiding along the structure layers. In this embodiment, the mesas are referred to as being "inverted" because the top portion of each mesa is immediately adjacent the substrate such that the light emitted by each mesa is directed away from the substrate. Without the inverted mesa structure of Fig. 2B, waveguiding along the structure layers could lead to inadvertent optical pumping of downconversion layers in one pixel by light emitted from a nearby pixel, a phenomenon known as "cross-talk" or color bleeding.

In the embodiment shown in Fig. 2B, a layer of dielectric material such as SiOx, SiNx, polyimide, etc. is deposited on substrate 51 and etched to form pit-defining structures 50, between which are left flat-bottom pits. Pit-defining structures 50 allow for the formation of the inverted mesa configuration of devices 24', 27' and 28' by the deposition of the layers comprising these devices.

Each of the inverted mesas of devices 24', 27' and 28' include reflective metal contact layer 56, isolation layer 53, blue OLED layer 20, dielectric layer 55, and red or green phosphors 21 and 22 for inverted mesas devices 28' and 27', respectively. Inverted mesa device 28' alternatively has a layer of green phosphor positioned either i) between blue OLED layer 20 and red phosphor 21, or ii) over red phosphor layer 21. Metal contact layer 56 may be made of aluminum, silver, Mg/Al and the like. In addition to serving as a reflector, metal contact layer 56 is preferably used as an interconnect. One distinct advantage to using metal contact layer 56 as an interconnect is that it is positioned beneath devices 24', 27' and 28' and is thus hidden from the viewer. The resulting display therefore has none of the dark lines between adjoining pixels as are frequently found in conventional display devices.

Each inverted mesa further includes a transparent contact area 52 with a thin (about 50-200Å) low work function metal layer 52A and a thicker (about 500-4000Å) ITO coating 52B. In comparison to the first embodiment, the polarities of batteries 30, 31, and 32 are reversed. As a result, the current flowing through devices 24', 27' and 28' is in the opposite direction relative to the embodiment of Fig. 2A, when forward biased for emitting light.

The embodiment shown in Fig. 2B is generally capable of higher resolutions than the embodiment shown in Fig. 2A. This is because the embodiment shown in Fig. 2A can result in a relatively broad light beam emitting from each of devices 24, 27 and 28 due to the relatively large distance between the light emitting regions and the substrate surface. In comparison, the light beams emitting from each of the inverted mesa structures of Fig. 2B do not pass through collimating dielectric layers or substrate material. The result is that relatively narrow light beams emit from inverted mesa devices 24', 27' and 28' of Fig. 2B when compared to those light beams emitted from each of the mesa devices shown in Fig. 2A.

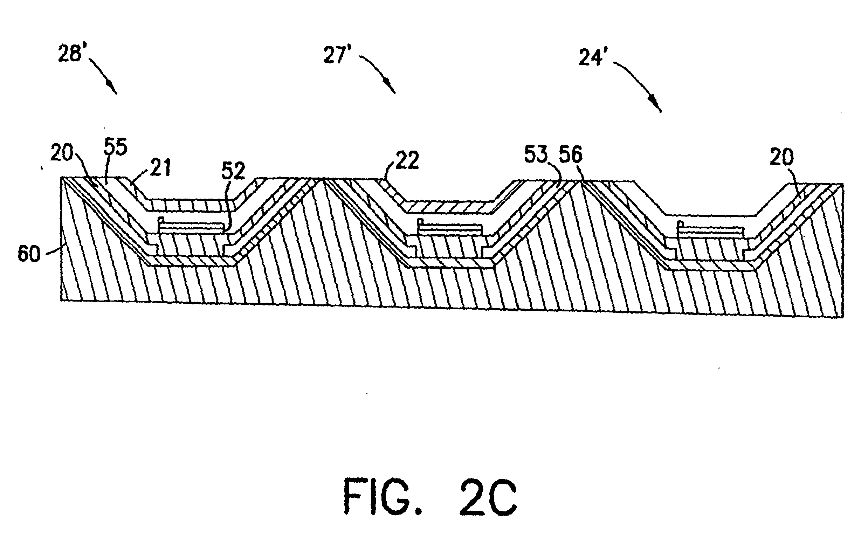

In addition to the configuration shown in Fig. 2B in which inverted mesas are formed by virtue of etched dielectric layer to form pit-defining structures 50, inverted mesas can be fabricated by forming devices 24', 27' and 28' on a patterned substrate 60 as shown in Fig. 2C. Patterned substrate 60 has pits therein, each pit having a substantially flat bottom surface and slanted side walls. Each side wall is slanted so as to create an obtuse angle with the bottom surface, wherein approximately 135°-145° is preferred. The depth of the pit can be relatively shallow, on the order of 1000-3000Å, and as wide as desired. For example, patterned substrate 60 is made of Si having the pits therein formed by a standard directional etching process. In addition to the pit structure shown in Figs. 2B and 2C, which has straight, slanted side walls, other cross-sections are also possible. For example, pits having a semicircular or similar cross-section are contemplated. Additionally, the mesas or inverted mesas of any embodiment of the present invention can be arranged, from a top view, in virtually any shape such as squares, triangles, circles, and hexagons.

In any of the embodiments as shown in Figs. 2A, 2B or 2C, there are preferably no materials with smaller refractive indexes relative to and between the emitting. layer of the OLED and the phosphor layers, such that substantially all photons emitted by the OLED are absorbed by the phosphor. This results in an increase in the efficiency of blue radiation transport into the red and green phosphors.

When used in multicolor applications, each pixel used in the displays of the present invention emits red, green, and blue light, either simultaneously or separately. Alternatively, when used in monochrome applications, each pixel emits a single color.

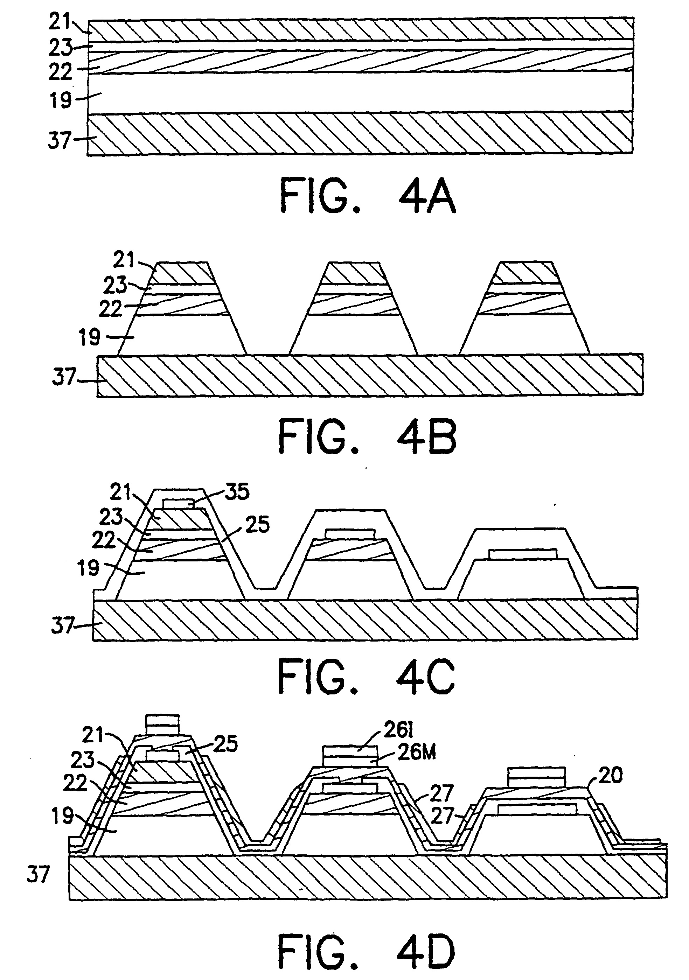

A method for making multicolor LED's on a common substrate 37 will now be described, for the embodiment of the invention shown in Fig. 2A. This method is schematically illustrated in Figs. 4A-4D, which are not intended to be drawn to scale. The following steps can be used to obtain the multicolor organic device array:
1) Depositing a transparent 5-10 µm dielectric layer 19 onto substrate 37. Dielectric layer 19 should preferably have a refractive index less than or equal to that of substrate 37. Layer 19 can be SiOₓ or Teflon, for example.
2) Depositing a green phosphor layer 22.
3) Depositing a thin, etch-stop, dielectric layer 23, such as SiOₓ.
4) Depositing a red phosphor layer 21. The device after this step appears as is shown in Fig. 4A.
5) Photolithographic patterning via reactive ion or wet chemical etching to create a two dimensional mesa-structure as shown in Fig. 4B.
6) Patterning and etching via appropriate chemical or reactive ion etch to remove said red phosphor 21 from one third of the mesas.
7) Patterning and etching via appropriate chemical or reactive ion etch to remove said green phosphor 22 from the second third of the mesas.
8) Depositing a transparent, conductive material such as ITO to make square contacts 35 on the top of said mesas.
9) Depositing metals (not shown) and patterning of stripe contacts to ITO to form stripe-contact metal columns. Such patterning can be done by shadow masking, lift-off or chloride reactive-ion etching of, for example, Al.
10) Depositing an isolation dielectric 25, such as SiNₓ. The device after this step appears as is shown in Fig. 4C.
11) Etching windows in the isolation dielectric via reactive ion or wet etching to obtain contact for blue OLED 20.
12) Depositing a blue OLED layer 20 over everything. Layer 20 can be of either SH or DH structure, as previously described.
13) Depositing metallization 26M and 26I over everything and patterning of row-metals stripe contacts and metal reflectors 47 on the sides of the mesas, as shown in Fig. 4D.

Although the above-listed method can be used to make the embodiment shown in Fig. 2A, other alternative steps are possible. For example, instead of depositing and etching layer 19 to form the mesa base for each of devices 24, 27 and 28, it is possible to directly etch substrate 37 for this same purpose, thus eliminating the need for layer 19. As another example, the phosphor and OLED layers can be deposited by aligned shadow masks onto pre-etched layer 19 or a pre-etched substrate 37.

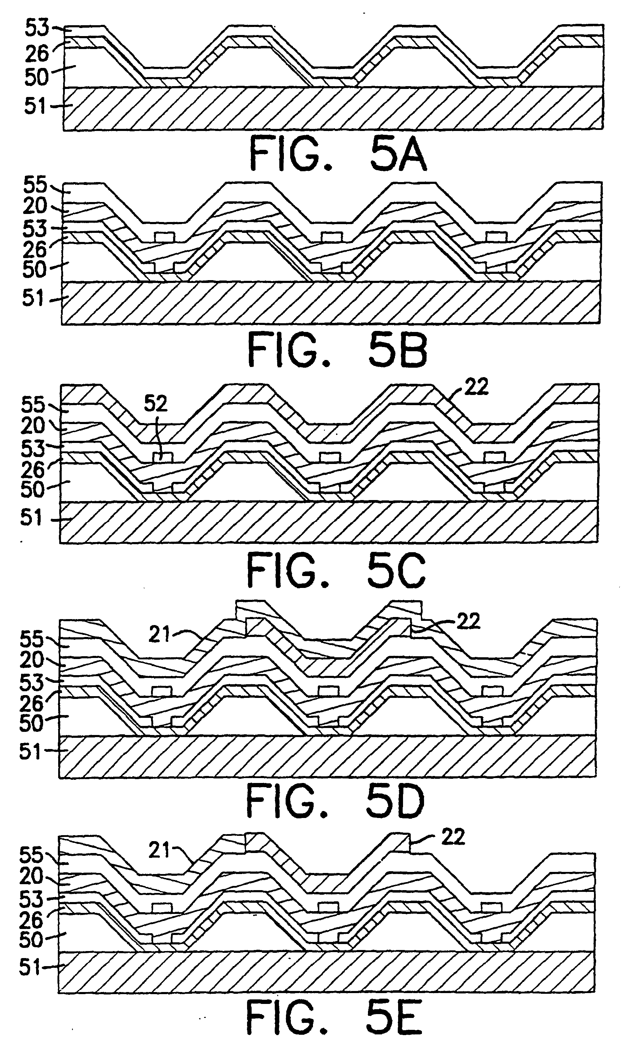

A method for making inverted multicolor LED's on a common substrate 51 will now be described, for the embodiment of the invention shown in Fig. 2B. This same method can be used to form the embodiment shown in Fig. 2C, with the exception that a patterned substrate 60 is used instead of flat substrate 51 with pit-defining structures 50 thereon. This method is schematically illustrated in Figs. 5A-5E, which are not intended to be drawn to scale. The following steps can be used to arrive at the embodiment shown in Fig. 2B:
1) Depositing a dielectric coating 50 onto substrate 51, which may be a metal foil, plastic layer, or other suitable substrate material. Layer 50 should be amenable to selective etching, and can be SiOₓ, SiNₓ, polyimide or Teflon, for example.
2) Etching dielectric coating to leave regions 50 such that flat-bottomed pits are formed therebetween.
3) Depositing metallization 56 over everything and metal patterning to create mesa-reflectors and row-metal stripe contacts.
4) Depositing an isolation layer 53, such as SiO₂. After this step, the device appears as shown in Fig. 5A.
5) Opening windows in said isolation coating for blue OLED 20 contacts.
6) Depositing a blue OLED layer 20 over everything. Layer 20 can be of either SH or DH structure, as previously described for the embodiment shown in Fig. 2A but inverted in layering.
7) Depositing a transparent ITO-contact 52.
8) Patterning said transparent ITO 52 for fabrication of column strip-contacts.
9) Depositing a layer 55 of dielectric material, such as SiOₓ. After this step, the device appears as shown in Fig. 5B.
10) Depositing a red phosphor layer 21, resulting in a configuration as shown in Fig. 5C.
11) Patterning and etching to remove said red phosphor 21 from a first two-thirds of the mesas.
12) Depositing a green phosphor layer 22, resulting in a configuration as shown in Fig. 5D.
13) Patterning and etching to remove said green phosphor 22 from a second two-thirds of the mesas, resulting in a configuration as shown in Fig. 5E.

Although Figs. 2A, 2B and 2C are directed to multicolor displays, the mesa and inverted mesa configurations of these figures can be applied to monochromatic displays in which each pixel includes a single mesa or inverted mesa structure which is only able to emit a single color.

In a third embodiment of the present invention, blue, green and red OLED are arranged in a stacked configuration 100 as shown in Fig. 2D. Such a stacked arrangement is described in U.S. application 08/354,674, filed December 13, 1994, and PCT International Application Publication No. WO 96/19792, filed December 6, 1995. The present invention makes use of this stacked arrangement in conjunction with a mesa structure to minimize waveguiding and maximize efficiency as previously discussed. In the embodiment shown in Fig. 2D, blue 20, green 110 and red 111 OLED's are stacked one upon the other, with each OLED separated one from the other by a transparent conductive layer 26 to enable each device to receive a separate bias potential to emit light through the stack. Each OLED 20, 110 and 111 may be of either SH or DH type, as previously described. As shown in Fig. 2D, the stacked arrangement of OLED's 20, 110 and 111 is positioned on conductive layer 112, dielectric layer 19 and transparent substrate 37.

Each conductive layer 26 comprises a low work function (preferably, <4 eV) metal layer 26M, such as Mg, Mg/Ag, and Li/Al, and an additional conductive layer 26I suitable for forming an electrical contact. Of course, all conductive layers between OLED's 20, 110 and 111, and between substrate 37 and OLED 20, must be substantially transparent. Conductive layer 26 on OLED 111, however, being at the top of the stack, need not be transparent and is preferably reflective. Terminal 26T is formed on metal layer 26 for electrical connection thereto, and may be made from In, Pt, Au, Ag, and combinations thereof, or any suitable material as is known in the art.

The stacked configuration 100 optionally comprises a layer 36 of low-loss, high refractive index dielectric material, such as TiO₂, between conductive layer 112 and dielectric layer 19. Layer 36 is especially preferred when conductive layer 112 is made from ITO, which is a high-loss material such that light from OLED layers 20, 110 and 111 can be easily waveguided in and absorbed by conductive layer 112. Layer 36 substantially eliminates waveguiding and absorption in the ITO, the light emitted from the OLED's 20, 110 and 111 now being substantially transmitted through layer 36. Moreover, layer 36 can have slanted side walls to reflected any waveguided light towards substrate 37.

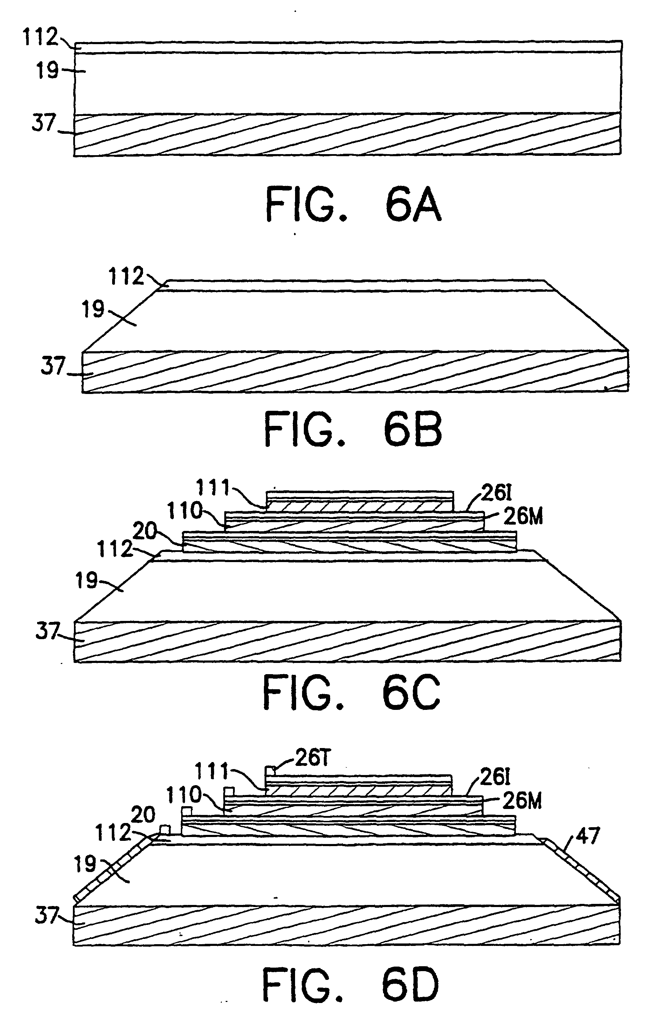

The fabrication of a stacked OLED pixel 100 is accomplished, for example, by shadow masking or dry etching.. For example, stacked OLED pixel 100 is made from the following steps, as schematically shown in Figs. 6A-6D:
1) Depositing a transparent 5-10 µm dielectric layer 19 onto transparent substrate 37. Dielectric layer 19 should have a refractive index less than or equal to that of substrate 37. Layer 19 can be SiOₓ or Teflon, for example.
2) Depositing a layer of transparent conductive material 112, such as ITO. After this step, the device appears as shown in Fig. 6A.
3) Etching to form a mesa structure, as shown in Fig. 6B.
4) Depositing a blue OLED layer 20. Layer 20 can be of either SH or DH structure, as previously described.
5) Depositing conductive layers 26M and 26I.
6) Depositing a green OLED layer 110. Layer 110 can be of either SH or DH structure, as previously described.
7) Depositing conductive layers 26M and 26I.
8) Depositing a red OLED layer 111. Layer 111 can be of either SH or DH structure, as previously described.
9) Depositing conductive layers 26M and 26I. After this step, the device appears as shown in Fig. 6C.
10) Depositing reflectors 47 on mesa side walls and terminals 26T on each of layers 26I. The final device appears as shown in Fig. 6D.

Further embodiments of the present invention are designed to concentrate light for maximized efficiency and high-brightness applications. Such light emitting articles each comprise a transparent substrate, a light reflecting layer on the substrate, a light reflecting structure in the form of a waveguiding layer on the reflective layer, and at least one OLED on the waveguiding layer, each OLED for emitting light of a predetermined color. The light reflecting layer has at least one opening therein. The light emitted from the OLED(s) is reflected off of the waveguiding layer side walls and the light reflecting layer, such that it is directed through the opening in the light reflecting layer for emission through the substrate. Thus, the light generated by an OLED of a relatively large length is concentrated into a relatively small emission area. The result is a high brightness, high resolution light emitting device.

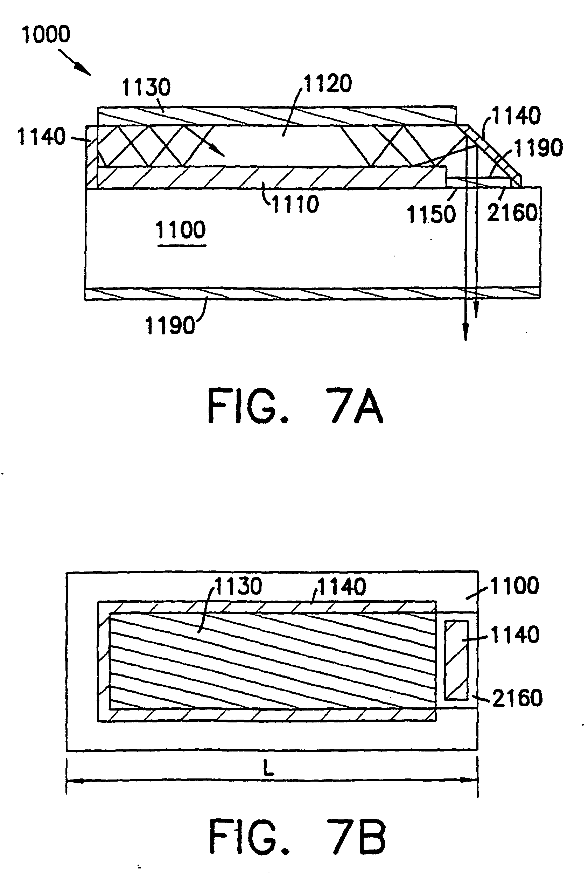

A fourth embodiment of the present invention is shown in Figs. 7A and 7B, which are side and top views, respectively. Light emitting device 1000 comprises substrate 1100, light reflecting layer 1110, waveguiding layer 1120 and OLED layer 1130. Light reflecting layer 1110 has at least one opening 1150 therein to allow for the passage of light emitted from OLED layer 1130. In this embodiment, waveguiding layer 1120 has a top surface, a bottom surface, and at least three sides. One of the sides 2160 of waveguiding layer 1120 forms an angle of less than 90°, preferably about 45°, with respect to substrate 1100. The remaining sides of waveguiding layer 1120 are substantially perpendicular to substrate 1100. Reflectors 1140 are optional on side 2160, and are preferable on the remaining sides of waveguiding layer 1120.

In the embodiment shown in Figs. 7A and 7B, light emitted from OLED layer 1130 is waveguided within waveguiding layer 1120, where it reflects off of light reflecting layer 1110 and the sides of waveguiding layer 1120 such that it is directed through opening 1150. The result is a concentrated beam of light which passes through opening 1150 and substrate 1100, as shown in Fig. 7A.

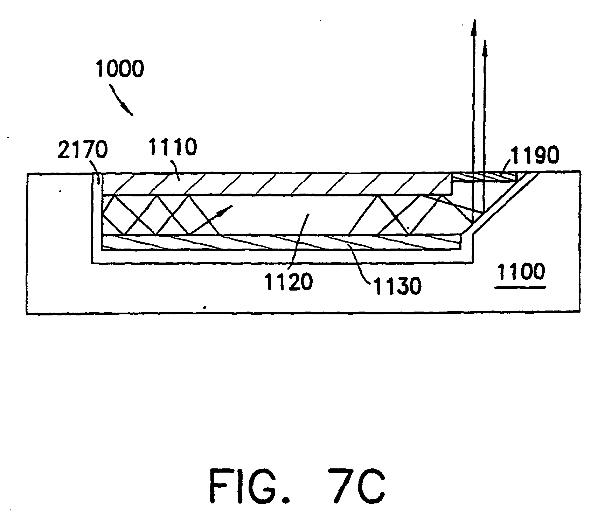

Although the embodiment shown in Figs. 7A and 7B is depicted as directing light through substrate 1100, the invention also includes "inverted" configurations such as that shown in Fig. 7C. In such a configuration, the device is arranged in a patterned substrate with pits therein such that light is directed in a direction away from the substrate. If the substrate in such devices is not reflective, a layer of reflective material 2170 should be included between OLED 1130 and substrate 1100. The depth of the pits in the patterned substrate can be relatively shallow, on the order of 1000-3000Å, and as wide as desired. For example, patterned substrate 1100 is made of Si having the pits therein formed by a standard directional etching process.

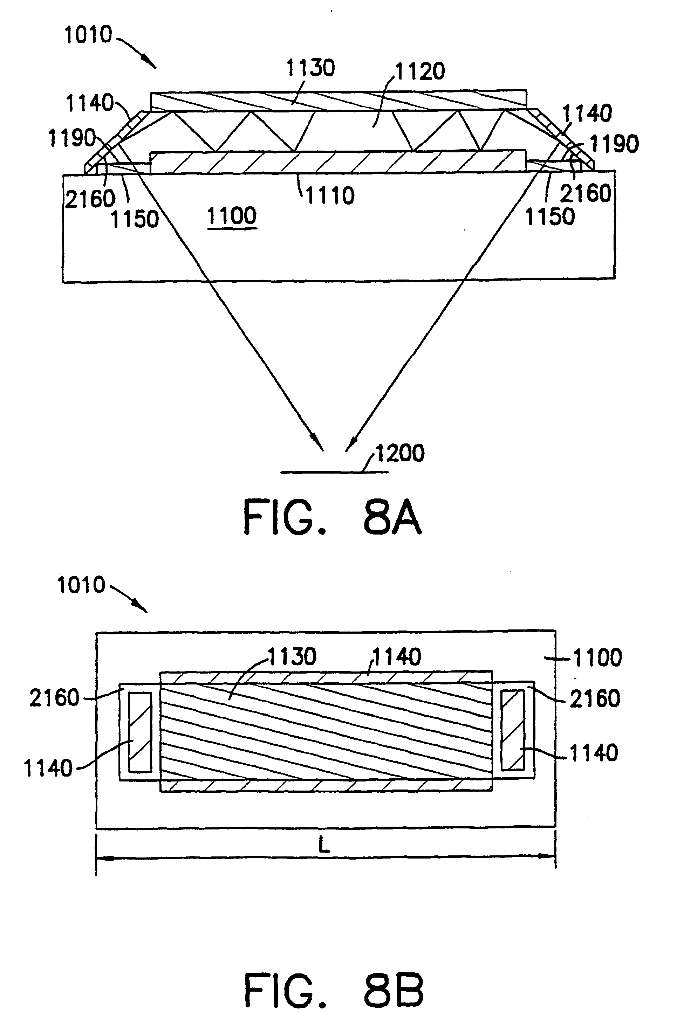

A fifth embodiment of the present invention is shown in Figs. 8A and 8B. Light emitting device 1010 comprises substrate 1100, light reflecting layer 1110, waveguiding layer 1120 and OLED layer 1130. At least two of the sides 2160 of waveguiding layer 1120 are at an angle of less than 90°, preferably about 30°, with respect to the substrate and the remainder of the sides are perpendicular to the substrate. Light reflecting layer 1110 has openings therein which are positioned below the sides of waveguiding layer 1120 which are at an angle of less than 90° with respect to the substrate. As shown in Fig. 8A, light emitted from OLED layer 1130 is waveguided within waveguiding layer 1120, where it reflects off of light reflecting layer 1110 and the sides of waveguiding layer 1120 such that it is directed through openings 1150. Light emitting device 1010 optionally includes reflectors 1140 to aid in the reflection of light emitted from OLED layer 1130. The light emerging from openings 1150 of device 1010 converges at some focal point 1200.

Substrate 1100 is generally fabricated from a transparent material, such as glass, quartz, sapphire or plastic. Reflectors 1140 are, for example, metallic mirrors or multilayer dielectric stacks, the latter of these being preferred. If metallic mirrors are used, reflectors 1140 are made from any suitable metal or alloy, preferably aluminum, silver, magnesium-aluminum alloy, and combinations thereof. If multilayer dielectric stacks, reflectors 1140 are made of any pair of dielectric materials having different refractive indices, such as TiO₂ and SiO₂, as is known in the art. Light reflecting layer 1110 is preferably made of a highly reflective multilayer dielectric stack.

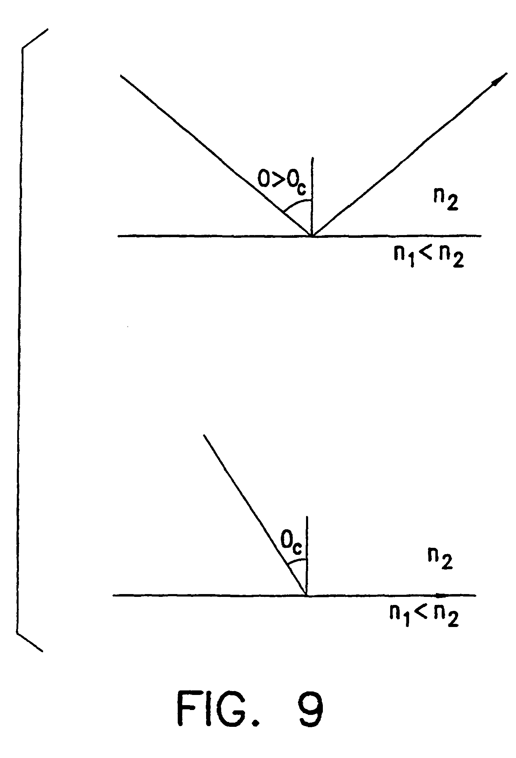

The need for optional reflectors 1140 depends upon the material used for waveguiding layer 1120, which is any suitable transparent dielectric material such as SiO₂, polyimide or TEFLON. Optimally, light which impinges upon the angled walls of waveguiding layer 1120 is completely reflected, thus resulting in total internal reflection. If this cannot be achieved because of the material used for waveguiding layer 1120, however, reflectors 1140 become necessary. For example, the material used for waveguiding layer and the material (or environment) surrounding waveguiding layer will have characteristic indices of refraction, n₂ and n₁, respectively. The critical angle, θ_{c}, shown in Fig. 9 and defined as the minimum angle at which total internal reflection will occur, relates to n₂ and n₁ according to the equation sin (θ_{c}) = (n₁ / n₂), where n₁<n₂. It can therefore be seen that as n₂, the refractive index of waveguiding layer 1120, increases, θ_{c}, decreases for a constant n₁ which is less than n₂. Accordingly, when the refractive index of waveguiding layer 1120 is much greater than that of the surrounding material (or environment), θ_{c} is minimized such that internal reflection becomes more likely. In this case, reflectors 1140 may not be necessary. Conversely, when n₂ is similar to n₁, θ_{c} is maximized such that internal reflection becomes less likely, and reflectors 1140 may therefore become necessary.

Although reflectors 1140 are shown as flat and straight members in the drawings, they may be of different shapes. For example, reflectors 1140 can be curved or parabolic in shape to have a focussing effect on impinging light beams.

In order to minimize internal losses, it is preferable that waveguiding layer 1120 should have a higher index of refraction than conductive layers 1500. In addition, the refractive index of waveguiding layer 1120 should be higher than that of the substrate in order to avoid leakage of light from waveguiding layer 1120 though light reflecting layer 1110 and into substrate 1100. Furthermore, the light emitting devices of the present invention can optionally comprise a layer 1170 of low-loss, high refractive index dielectric material, such as TiO₂, beneath conductive layers 1500. Layer 1170 is especially preferred when conductive layers 1500 are made from ITO, which is a high-loss material such that it can absorb light emitted from OLED layer 1130. The refractive indexes for TiO₂ and ITO are approximately 2.6 and 2.2, respectively. Layer 1170 therefore substantially eliminates waveguiding and absorption in the ITO. Although the refractive index of layer 1170 should be greater than that of layer 1500, it should be less than the refractive index of waveguiding layer 1120 so that the emitted light can easily pass from layer 1170 to layer 1120. In yet a further effort to reduce internal losses, a layer 1190 of low-loss, high refractive index dielectric material is optionally positioned at openings 1150 to serve as an antireflection coating to help facilitate the transmission of light from waveguiding layer 1120 into substrate 1100. Layer 1190 can also be positioned under substrate 1100 as shown in Figs. 7A and 8A. Layer 1190 is TEFLON, for example.

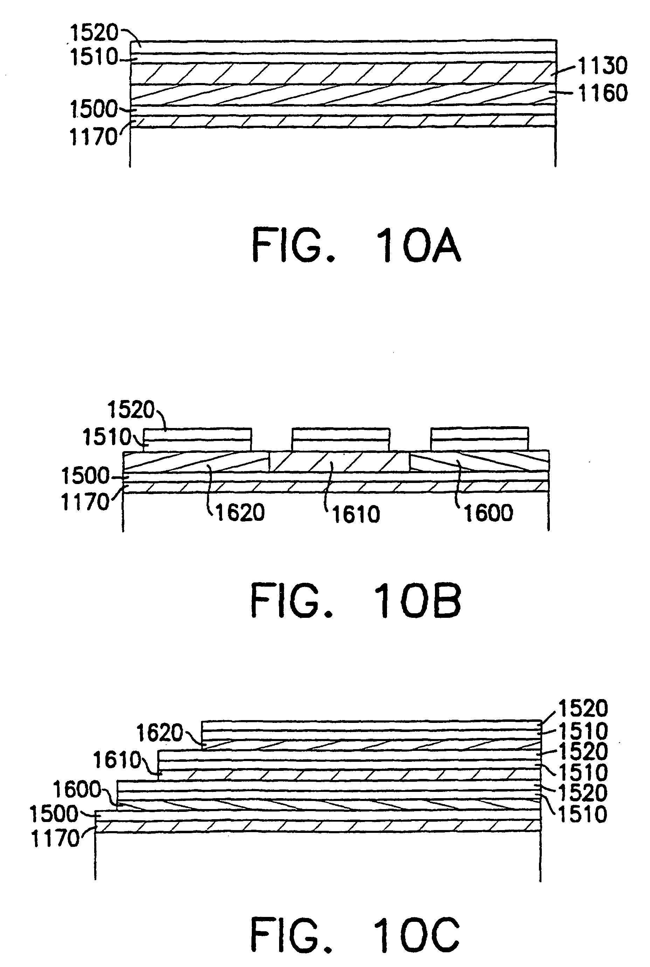

In any embodiment of the present invention, OLED layer 113 can be an OLED of single or double heterostructure configuration, as are known in the art. For simplicity, the OLEDs used in the present invention are shown as single layers in the drawings even though each OLED actually comprises multiple sub-layers if the OLED is not a single-layer polymer, as is known in the art. In addition, there are numerous electrode layers required for the operation of OLED layer 113, as shown in Figs. 10A-10C,

As shown in Fig. 10A, a low work function (preferably, <4 eV) metal layer 1510 is formed on top of OLED layer 1130. Suitable candidates for metal layer 1510 include Mg, Mg/Ag, and Li/Al. Metal layer 1510 serves as a contact material for OLED layer 1130 and as a reflective material for reflection of impinging light beams. Deposited on the top of metal layer 1510 is another conductive layer 1520 suitable for forming an electrical contact. Conductive layer 1520 is made of ITO, Al, Ag or Au, for example. Light emission from the OLED 1130 occurs when a voltage is applied between conductive layer 150 and conductive layer 1520, thereby causing emission from the EL of OLED layer 1130. A layer of phosphor 1160 may optionally be included for light energy downconversion of the light emitted from the OLED emission layer to a desired color. The embodiment shown in Fig. 10A will produce monochromatic light emission.

Alternatively, to facilitate multicolor applications, OLED layer 1130 includes a blue OLED 1600, a green OLED 1610, and a red OLED 1620 as shown in Fig. 10B. Each of the blue, green, and red OLEDs can be individually addressed for the independent emission of blue, green, and red light, respectively.

Alternatively, blue, green and red OLEDs are arranged in a stacked configuration as shown in Fig. 10C. Such a stacked arrangement is described in U.S. Patent 5,707,745 and PCT International Application Publication No. WO 96/19792, filed December 6, 1995. In the embodiment shown in Fig. 10C, blue 1600, green 1610 and red 1620 OLED's are stacked one upon the other, with each OLED separated one from the other by layers 1510 and 1520 to enable each device to receive a separate bias potential to emit light through the stack. In this embodiment, metal layers 1520 which are positioned between OLED materials (e.g., between layers 1600 and 1610, and between layers 1610 and 1620) are thin enough to be transparent, and metal layer 1520 on top of the red OLED 1620, being the topmost conductive layer in the device, is thick enough to reflect impinging light beams. Each OLED 1600, 1610 and 1620 may be of either SH or DH type, as previously described. As shown in Fig. 10C, the stacked arrangement of OLED's 1600, 1610 and 1620 is positioned on conductive layer 1500.

The deposition techniques for any of the above-listed methods and materials are well-known in the art. For example, the preferred method of depositing the OLED layers is by thermal evaporation or spin coating; the preferred method of depositing metal layers is by thermal or electron-beam evaporation or sputtering; the preferred method of depositing ITO is by electron-beam evaporation or sputtering; the preferred method of depositing the phosphor layers is by thermal evaporation or sputtering; and the preferred method of depositing dielectrics is by plasma-enhanced chemical vapor deposition or electron-beam evaporation.

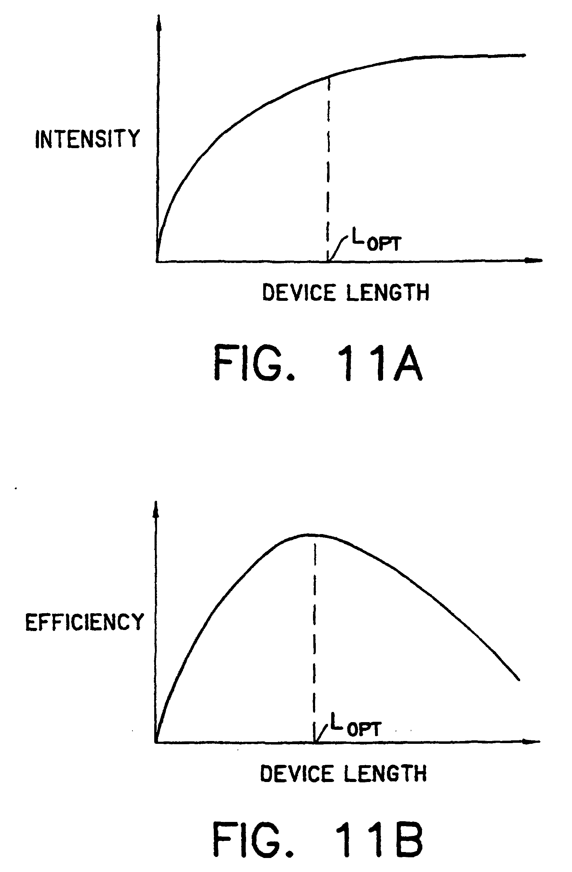

A significant advantage of the embodiments of the present invention which make use of light reflecting layer 1110 is that the light generated by an OLED of a relatively large length is concentrated into a relatively small emission area. The result is a high brightness, high resolution light emitting device. As the length L of each device of the present invention increases, the efficiency of the device is expected to increase until some optimum length (L_{OPT}) is reached above which losses within the device became significant and efficiency therefore decreases. This phenomenon is graphically shown in Fig. 11. As such, the embodiment shown in Fig. 8, having two openings 1150 in light reflecting layer 1110 and converging light beams to focal point 1200, is generally twice as bright as the embodiment shown in Fig. 7. The embodiment shown in Fig. 8 can thus be half the length of the embodiment shown in Fig. 7, but yet have the same resulting light intensity.

The high brightness light emission resulting from embodiments of the present invention which make use of light reflecting layer 1110 make such devices useful for xerography, copying, printing and display applications, and any other such applications where high brightness, monochromatic or multicolor light emission is required. Depending on the application, the embodiments as shown and described can be used singularly or as a plurality of pixels. For example, where the present invention is used to form a flat-panel linescan display device comprising a plurality of pixels, each light emitting device as herein described can represent an individual pixel or part thereof.

The metal bidentate complexes which may be used for the blue emitting OLED's of any embodiment of the present invention have the formula MDL⁴₂ wherein M is selected from trivalent metals of Groups 3-13 of the Periodic Table and Lanthanides. The preferred metal ions are Al⁺³, Ga⁺³, In⁺³ and Sc⁺³. D is a bidentate ligand such as 2-picolylketones, 2-quinaldylkentones and 2-(o-phenoxy) pyridine ketones. The preferred groups for L⁴ include acetylacetonate, compounds of the formula OR³R wherein R³ is selected from Si and C, and R is selected from hydrogen, substituted and unsubstituted alkyl, aryl and heterocyclic groups; 3,5-di(t-bu) phenol; 2,6-di(t-bu) phenol; 2,6-di(t-bu) cresol; and H₂Bpz₂. By way of example, the wavelength resulting from measurement of photoluminescence in the solid state of aluminum (picolymethylketone) bis [2,6-di(t-bu) phenoxide] is 420nm. The cresol derivative of this compound also measured 420nm. Aluminum (picolylmethylketone) bis (OsiPh₃) and scandium (4-methoxy-picolylmethylketone) bis (acetylacetonate) each measured 433nm, while aluminum [2-(O-phenoxy)pyridine] bis [2,6-di(t-bu) phenoxide] measured 450nm.

Examples of green OLED emissive materials include tin (iv) metal complexes, such as those having the formula SnL¹₂L²₂ where L¹ is selected from salicylaldehydes, salicyclic acid or quinolates (e.g. 8-hydroxyquinoline). L² can be substituted and unsubstituted alkyl, aryl and heterocyclic groups. When L¹ is a quinolate and L² is a phenyl, for example, the tin (iv) metal complex will have an emission wavelength of 504nm.

Examples of red OLED emissive materials include divalent metal maleonitriledithiolate ("mnt") complexes, such as those described by C.E. Johnson et al. in "Luminescent Iridium(I), Rhodium(I), and Platinum(II) Dithiolate Complexes," 105 Journal of the American Chemical Society 1795 (1983). For example, the mnt [Pt (Pph₃)₂] has a characteristic wavelength emission of 652nm.

Additional OLED materials are known in the art (see, e.g., U.S. Patent No. 5,294,870 to Tang et al., entitled "Organic Electroluminescent Multicolor Image Display Device"; Hosokawa et al., "Highly efficient blue electroluminescence from a distyrylarylene emitting layer with a new dopant," 67 Applied Physics Letters 3853-55 (December 1995); Adachi et al., "Blue light-emitting organic electroluminescent devices," 56 Applied Physics Letters 799-801 (February 1990); Burrows et al., "Color-Tunable Organic Light Emitting Devices," 69 Applied Physics Letters 2959-61 (November 1996)). Distyrylarylene derivatives such as those described in Hosokawa et al. are a preferred class of compounds.

The red and green emitting fluorescent media used in the present invention are well-known in the art. U.S. Patent Nos. 4,769,292 and 5,294,870. These fluorescent dyes can be dissolved in matrix polymer such as polymethylmethacrylate and many of the suitable dyes were originally developed for plastic lasers. Examples of red fluorescent dyes are 4-dicyanomethylene-4H-pyrans and 4-dicyanomethylene-4H-thiopyrans. Examples of green fluorescent dyes include the polymethine dyes such as cyanines, merocyanines and tri-, tetra, and polynuclear cyanines and merocyanines, oxonols, hemioxanols, styryls, merostyryls and streptocyanines.

The devices of the present invention provide a low cost, high resolution, high brightness, monochromatic or multicolor, flat panel display of any size. This widens the scope of this invention to include displays as small as a few millimeters to as large as the size of a building. The images created on the display could be text or illustrations in full color, in any resolution depending on the size of the individual LED's. The devices of the present invention are therefore appropriate for an extremely wide variety of applications including electronic displays, lasers, lighting devices, and display devices for use in billboards and signs, computer monitors, telecommunications devices such as telephones, televisions, large area wall screens, theater screens and stadium screens, for example. Embodiments of the present invention in which the emitted light is directed in a direction away from the substrate are particularly useful for xerographic applications, as such embodiments allow for close positioning to print paper without the use of lenses.

Those with skill in the art may recognize various modifications to the embodiments of the invention described and illustrated herein. Such modifications are meant to be covered by the scope of the appended claims.

## Claims

1. A light emitting article comprising:
a substrate;
a light reflecting structure positioned in or on said substrate, said light reflecting structure **characterized by** a top portion and a bottom portion wherein the top portion is narrower than the bottom portion; and
an organic light emitting device positioned in or on said light reflecting structure;
wherein said light reflecting structure directs light emitted from said organic light emitting device either towards the bottom portion of said light reflecting structure and away from the substrate or through the bottom portion of said light reflecting structure.

2. The light emitting article of claim 1, wherein
said substrate is transparent; and
said light reflecting structure is positioned on said substrate with the bottom portion of the light reflecting structure being immediately adjacent to said substrate such that light emitted from said organic light emitting device is directed towards said substrate.

3. The light emitting article of claim 2, wherein
said light reflecting structure includes a side wall that intersects the bottom portion at an acute angle.

4. The light emitting article of claim 3, further comprising a reflector on said side wall.

5. The light emitting article of claim 2, wherein
said light reflecting structure includes multiple side walls; and
each of the side walls intersects the bottom portion at an acute angle.

6. The light emitting article of claim 5, further comprising a reflector on at least one of said multiple side walls.

7. The light emitting article of claim 5, wherein said light reflecting structure is a mesa structure.

8. The light emitting article of claim 7, wherein:
said organic light emitting device is positioned over said mesa structure; and
said organic light emitting device comprises:
an anode over said mesa structure;
a first organic layer over said anode, wherein said first organic layer is a hole transporting layer;
a second organic layer over said first organic layer, wherein said second organic layer is an emissive and electron transporting layer; and
a cathode over said second organic layer.

9. The light emitting article of claim 7, wherein:
said organic light emitting device is positioned over said mesa structure; and
said organic light emitting device comprises:
an anode over said mesa structure;
a first organic layer over said anode, wherein said first organic layer is a hole transporting layer;
a second organic layer over said first organic layer, wherein said second organic layer is an emissive layer;
a third organic layer over said second organic layer, wherein said third organic layer is an electron transporting layer; and
a cathode over said third organic layer.

10. The light emitting article of claim 7, wherein said organic light emitting device is positioned over said mesa structure.

11. The light emitting article of claim 7, wherein said organic light emitting device is positioned within said mesa structure.

12. The light emitting article of claim 1, wherein:
said light emitting article is a multicolor display comprising a plurality of pixels, each of said pixels comprising three of said light reflecting structures, the first of said light reflecting structures being a blue light emitter, the second of said light reflecting structures being a green light emitter, and the third of said light reflecting structures being a red light emitter.

13. The light emitting article of claim 12, wherein said organic light emitting device emits blue light.

14. The light emitting article of claim 13, wherein the second of said light reflecting structures comprises a green downconversion phosphor layer that converts substantially all of the blue light emitted from said organic light emitting device to green light.

15. The light emitting article of claim 13, wherein the third of said light reflecting structures comprises a red downconversion phosphor layer that converts substantially all of the blue light emitted from said organic light emitting device to red light.

16. The light emitting article of claim 1, further comprising at least one additional organic light emitting device.

17. The light emitting article of claim 16, wherein said organic light emitting device and said at least one additional organic light emitting device are arranged in a stacked arrangement.

18. The light emitting article of claim 17, wherein said organic light emitting device and said at least one additional organic light emitting device are independently addressable.

19. The light emitting article of claim 2, wherein
said light reflecting structure includes at least three side walls; and
one of said side walls forms an acute angle with respect to said substrate and the remainder of said side walls are substantially perpendicular to said substrate.

20. The light emitting article of claim 19, further comprising a light reflecting layer on said substrate, said light reflecting layer having at least one opening therein, wherein light emitted from said organic light emitting device is directed through said at least one opening for emission through said substrate.

21. The light emitting article of claim 20, wherein
said light reflecting layer has one opening therein, said opening positioned directly beneath said side of said light reflecting structure that forms an acute angle with respect to said substrate.

22. The light emitting article of claim 21, wherein said acute angle is about 45°.

23. The light emitting article of claim 19, wherein
said light reflecting structure includes at least three side walls; and
a plurality of said at least three side walls form angle of less than 90° with respect to said substrate and any remaining sides of said at least three sides are perpendicular to said substrate.

24. The light emitting article of claim 23, wherein
said light reflecting layer has a plurality of openings therein, each of said openings positioned directly beneath each of said plurality of said at least three side walls that form angle of less than 90° with respect to said substrate.

25. The light emitting article of claim 24, wherein light emitted through said plurality of openings converges to a common focal point.

26. The light emitting article of claim 1, wherein
the top portion of said light reflecting structure is immediately adjacent to said substrate such that light emitted from said organic light emitting device is directed away from said substrate.

27. The light emitting article of claim 26, wherein
said light reflecting structure is a pit within the top surface of said substrate; and the bottom portion of said light reflecting structure is flush with the top surface of said substrate.

28. The light emitting article of claim 26, further comprising at least one pit-defining structure on said substrate.

29. The light emitting article of claim 28, wherein said light reflecting structure is a pit formed by said at least one pit-defining structure.

## Patentansprüche

1. Licht emittierender Gegenstand, der folgendes umfasst:
- ein Substrat,
- eine Licht reflektierende Struktur, die in oder auf dem Substrat angeordnet ist, wobei die Licht reflektierende Struktur durch einen oberen Bereich und einen unteren Bereich gekennzeichnet ist, wobei der obere Bereich schmaler als der untere Bereich ist, und
- eine organische Licht emittierende Vorrichtung, die in oder auf der Licht reflektierenden Struktur angeordnet ist,
wobei die Licht reflektierende Struktur das aus der organischen Licht emittierenden Vorrichtung gesendete Licht entweder auf den unteren Bereich der Licht reflektierenden Struktur und weg vom Substrat oder durch den unteren Bereich der Licht reflektierenden Struktur leitet.

2. Licht emittierender Gegenstand nach Anspruch 1, wobei das Substrat durchsichtig ist, und die Licht reflektierende Struktur auf dem Substrat mit dem unteren Bereich der Licht reflektierenden Struktur unmittelbar an das Substrat angrenzend angeordnet ist, so dass das von der organischen Licht emittierenden Vorrichtung gesendete Licht auf das Substrat hingeleitet wird.

3. Licht emittierender Gegenstand nach Anspruch 2, wobei die Licht reflektierende Struktur eine Seitenwand einschließt, die den unteren Bereich unter einem spitzen Winkel schneidet.

4. Licht emittierender Gegenstand nach Anspruch 3, der weiterhin einen Reflektor an der Seitenwand umfasst.

5. Licht emittierender Gegenstand nach Anspruch 2, wobei die Licht reflektierende Struktur mehrere Seitenwände umfasst, und jede der Seitenwände den unteren Bereich unter einem spitzen Winkel schneidet.

6. Licht emittierender Gegenstand nach Anspruch 5, der weiterhin einen Reflektor auf mindestens einer der mehreren Seitenwände umfasst.

7. Licht emittierender Gegenstand nach Anspruch 5, wobei die Licht reflektierende Struktur eine MESA-Struktur ist.

8. Licht emittierender Gegenstand nach Anspruch 7, wobei
- die organische Licht emittierende Vorrichtung über der MESA-Struktur angeordnet ist; und
- die organische Licht emittierende Vorrichtung folgendes umfasst:
- eine Anode über der MESA-Struktur,
- eine erste organische Schicht über der Anode, wobei die erste organische Schicht eine gelochte transportierende Schicht ist,
- eine zweite organische Schicht über der ersten organischen Schicht, wobei die zweite organische Schicht eine emittierende und Elektronen transportierende Schicht ist, und
- eine Kathode über der zweiten organischen Schicht.

9. Licht emittierender Gegenstand nach Anspruch 7, wobei
- die organische Licht emittierende Vorrichtung über der MESA-Struktur angeordnet ist; und
- die organische Licht emittierende Vorrichtung folgendes umfasst:
- eine Anode über der MESA-Struktur,
- eine erste organische Schicht über der Anode, wobei die erste organische Schicht eine gelochte transportierende Schicht ist,
- eine zweite organische Schicht über der ersten organischen Schicht, wobei die zweite organische Schicht eine emittierende Schicht ist, und
- eine dritte organische Schicht über der zweiten organischen Schicht, wobei die dritte organische Schicht eine Elektronen transportierende Schicht ist, und
- eine Kathode über der dritten organischen Schicht.

10. Licht emittierender Gegenstand nach Anspruch 7, wobei die organische Licht emittierende Vorrichtung über der MESA-Struktur angeordnet ist.

11. Licht emittierender Gegenstand nach Anspruch 7, wobei die organische Licht emittierende Vorrichtung in der MESA-Struktur angeordnet ist.

12. Licht emittierender Gegenstand nach Anspruch 1, wobei der Licht emittierende Gegenstand eine mehrfarbige Anzeige ist, die eine Vielzahl von Pixeln umfasst, wobei jedes Pixel drei der Licht reflektierenden Strukturen umfasst, wobei die erste der Licht reflektierenden Strukturen blaues Licht aussendet, die zweite der Licht reflektierenden Strukturen grünes Licht aussendet und die dritte der Licht reflektierenden Strukturen rotes Licht aussendet.

13. Licht emittierender Gegenstand nach Anspruch 12, wobei die organische Licht emittierende Vorrichtung blaues Licht aussendet.

14. Licht emittierender Gegenstand nach Anspruch 13, wobei die zweite der Licht reflektierenden Strukturen eine grüne Down-Conversion-Leuchtstoffschicht umfasst, die im Wesentlichen das gesamte von der organischen Licht emittierenden Vorrichtung ausgesendete blaue Licht in grünes Licht wandelt.

15. Licht emittierender Gegenstand nach Anspruch 13, wobei die dritte der Licht reflektierenden Strukturen eine rote Down-Conversion-Leuchtstoffschicht umfasst, die im Wesentlichen das gesamte von der organischen Licht emittierenden Vorrichtung ausgesendete blaue Licht in rotes Licht wandelt.

16. Licht emittierender Gegenstand nach Anspruch 1, der weiterhin mindestens eine zusätzliche organische Licht emittierende Vorrichtung umfasst.

17. Licht emittierender Gegenstand nach Anspruch 16, wobei die organische Licht emittierende Vorrichtung und die mindestens eine zusätzliche organische Licht emittierende Vorrichtung in einer gestapelten Anordnung angeordnet sind.

18. Licht emittierender Gegenstand nach Anspruch 17, wobei die organische Licht emittierende Vorrichtung und die mindestens eine zusätzliche organische Licht emittierende Vorrichtung unabhängig voneinander adressierbar sind.

19. Licht emittierender Gegenstand nach Anspruch 2, wobei die Licht reflektierende Struktur mindestens drei Seitenwände umfasst und eine der Seitenwände einen spitzen Winkel im Hinblick auf das Substrat und die übrigen Seitenwände bildet, die im Wesentlichen senkrecht auf das Substrat stehen.

20. Licht emittierender Gegenstand nach Anspruch 19, der zusätzlich eine Licht reflektierende Schicht auf dem Substrat umfasst, wobei die Licht reflektierende Schicht mindestens eine Öffnung aufweist, wobei das aus der organischen Licht emittierenden Vorrichtung ausgesendete Licht durch die mindestens eine Öffnung zur Emission durch das Substrat geleitet wird.

21. Licht emittierender Gegenstand nach Anspruch 20, wobei die Licht reflektierende Schicht eine Öffnung aufweist, wobei die Öffnung direkt unterhalb der Seite der Licht reflektierenden Struktur angeordnet ist, die einen spitzen Winkel im Hinblick auf das Substrat bildet.

22. Licht emittierender Gegenstand nach Anspruch 21, wobei der spitze Winkel ungefähr 45° beträgt.

23. Licht emittierender Gegenstand nach Anspruch 19, wobei die Licht reflektierende Struktur mindestens drei Seitenwände umfasst, und eine Vielzahl der mindestens drei Seitenwände im Hinblick auf das Substrat einen Winkel von weniger als 90° bilden und die übrigen Seiten der mindestens drei Seiten senkrecht auf das Substrat stehen.

24. Licht emittierender Gegenstand nach Anspruch 23, wobei die Licht reflektierende Schicht eine Vielzahl von darin befindlichen Öffnungen aufweist, wobei jede der Öffnungen direkt unterhalb jeder der Vielzahl der mindestens drei Seitenwände angeordnet ist, die einen Winkel von weniger als 90° im Hinblick auf das Substrat bilden.

25. Licht emittierender Gegenstand nach Anspruch 24, wobei das Licht, welches durch die Vielzahl von Öffnungen gesendet wird, auf einen gemeinsamen Brennpunkt zusammenläuft.

26. Licht emittierender Gegenstand nach Anspruch 1, wobei der obere Bereich der Licht reflektierenden Struktur unmittelbar an das Substrat angrenzt, so dass das aus der organischen Licht emittierenden Vorrichtung gesendete Licht von dem Substrat weggeleitet wird.

27. Licht emittierender Gegenstand nach Anspruch 26, wobei die Licht reflektierende Struktur eine Vertiefung in der oberen Oberfläche des Substrats darstellt, und der untere Bereich der Licht reflektierenden Struktur bündig mit der oberen Oberfläche des Substrats schließt.

28. Licht emittierender Gegenstand nach Anspruch 26, der zusätzlich mindestens eine Struktur auf dem Substrat aufweist, die eine Vertiefung darstellt.

29. Licht emittierender Gegenstand nach Anspruch 28, wobei die Licht reflektierende Struktur eine Vertiefung ist, die durch die mindestens eine eine Vertiefung definierende Struktur gebildet wird.

## Revendications

1. Article émetteur de lumière, comprenant:
un substrat;
une structure réflectrice de lumière positionnée dans ou sur ledit substrat, ladite structure réflectrice de lumière étant **caractérisée par** une portion haute et une portion basse, dans lequel la portion haute est plus étroite que la portion basse; et
un dispositif émetteur de lumière organique positionné dans ou sur ladite structure réflectrice de lumière ;
dans lequel ladite structure réflectrice de lumière dirige la lumière émise par ledit dispositif émetteur de lumière organique soit dans la direction de la portion basse de ladite structure réflectrice de lumière et en se détournant du substrat, soit à travers la portion basse de ladite structure réflectrice de lumière.

2. Article émetteur de lumière de la revendication 1, dans lequel
ledit substrat est transparent ; et
ladite structure réflectrice de lumière est positionnée sur ledit substrat, la portion basse de la structure réflectrice de lumière étant immédiatement adjacente audit substrat, de telle sorte que la lumière émise par ledit dispositif émetteur de lumière organique soit dirigée dans la direction dudit substrat.

3. Article émetteur de lumière de la revendication 2, dans lequel
ladite structure réflectrice de lumière inclut une paroi latérale qui coupe en intersection la portion basse à un angle aigu.

4. Article émetteur de lumière de la revendication 3, comprenant en outre un réflecteur sur ladite paroi latérale.

5. Article émetteur de lumière de la revendication 2, dans lequel
ladite structure émettrice de lumière inclut des parois latérales multiples; et
chacune des parois latérales coupe en intersection la portion basse à un angle aigu.

6. Article émetteur de lumière de la revendication 5, comprenant en outre un réflecteur sur au moins une desdites parois latérales multiples.

7. Article émetteur de lumière de la revendication 5, dans lequel ladite structure réflectrice de lumière est une structure mesa.

8. Article émetteur de lumière de la revendication 7, dans lequel:
ledit dispositif émetteur de lumière organique est positionné sur ladite structure mesa ; et
ledit dispositif émetteur de lumière organique comprend:
une anode par dessus ladite structure mesa;
une première couche organique par dessus ladite anode,
dans lequel ladite première couche organique est une couche de transport des trous ;
une deuxième couche organique par dessus ladite première couche organique, dans lequel ladite deuxième couche organique est une couche émettrice et de transport des électrons ; et
une cathode par dessus ladite deuxième couche organique.

9. Article émetteur de lumière de la revendication 7, dans lequel:
ledit dispositif émetteur de lumière organique est positionné par dessus ladite structure mesa ; et
ledit dispositif émetteur de lumière organique comprend:
une anode par dessus ladite structure mesa ;
une première couche organique par dessus ladite anode, dans lequel ladite première couche organique est une couche de transport des trous ;
une deuxième couche organique par dessus ladite première couche organique, dans lequel ladite deuxième couche organique est une couche émettrice ;
une troisième couche organique par dessus ladite deuxième couche organique, dans lequel ladite troisième couche organique est une couche de transport des électrons ; et
une cathode par dessus ladite troisième couche organique.

10. Article émetteur de lumière de la revendication 7, dans lequel ledit dispositif émetteur de lumière organique est positionné par dessus ladite structure mesa.

11. Article émetteur de lumière de la revendication 7, dans lequel ledit dispositif émetteur de lumière organique est positionné à l'intérieur de ladite structure mesa.

12. Article émetteur de lumière de la revendication 1, dans lequel:
ledit article émetteur de lumière est un écran multicolore comprenant une pluralité de pixels, chacun desdits pixels comprenant trois desdites structures réflectrices de lumière, la première desdites structures réflectrices de lumière étant un émetteur de lumière bleue, la deuxième desdites structures réflectrices de lumière étant un émetteur de lumière verte et la troisième desdites structures réflectrices de lumière étant un émetteur de lumière rouge.

13. Article émetteur de lumière de la revendication 12, dans lequel ledit dispositif émetteur de lumière organique émet de la lumière bleue.

14. Article émetteur de lumière de la revendication 13, dans lequel la deuxième desdites structures réflectrices de lumière comprend une couche de phosphore verte de conversion vers le bas, qui convertit essentiellement toute la lumière bleue émise par ledit dispositif émetteur de lumière organique en lumière verte.

15. Article émetteur de lumière de la revendication 13, dans lequel la troisième desdites structures réflectrices de lumière comprend une couche de phosphore rouge de conversion vers le bas, qui convertit essentiellement toute la lumière bleue émise par ledit dispositif émetteur de lumière organique en lumière rouge.

16. Article émetteur de lumière de la revendication 1, comprenant en outre au moins un dispositif additionnel émetteur de lumière organique.

17. Article émetteur de lumière de la revendication 16, dans lequel ledit dispositif émetteur de lumière organique et au moins un dit dispositif additionnel émetteur de lumière organique sont agencés en empilement.

18. Article émetteur de lumière de la revendication 17, dans lequel ledit dispositif émetteur de lumière organique et au moins un dit dispositif additionnel émetteur de lumière organique sont adressables indépendamment.

19. Article émetteur de lumière de la revendication 2, dans lequel:
ladite structure réflectrice de lumière inclut au moins trois parois latérales ; et
une desdites parois latérales forme un angle aigu par rapport audit substrat et lesdites parois latérales restantes sont substantiellement perpendiculaires audit substrat.

20. Article émetteur de lumière de la revendication 19, comprenant en outre une couche réflectrice de lumière sur ledit substrat, ladite couche réflectrice de lumière comportant au moins une ouverture, dans lequel la lumière émise par ledit dispositif émetteur de lumière organique est dirigée à travers au moins une dite ouverture en vue d'une émission à travers ledit substrat.

21. Article émetteur de lumière de la revendication 20, dans lequel
ladite couche réflectrice de lumière comporte une ouverture, ladite ouverture étant positionnée directement en dessous dudit côté de ladite structure réflectrice de lumière qui forme un angle aigu par rapport audit substrat.

22. Article émetteur de lumière de la revendication 21, dans lequel ledit angle aigu est d'environ 45°.

23. Article émetteur de lumière de la revendication 19, dans lequel
ladite structure réflectrice de lumière inclut au moins trois parois latérales ; et
une pluralité desdites au moins trois parois latérales forme un angle inférieur à 90° par rapport audit substrat et tous les côtés restants desdits au moins trois côtés sont perpendiculaires audit substrat.

24. Article émetteur de lumière de la revendication 23, dans lequel
ladite couche réflectrice de lumière comporte une pluralité d'ouvertures, chacune desdites ouvertures étant positionnée directement en dessous de chacune de ladite pluralité d'au moins trois parois latérales qui forme un angle inférieur à 90° par rapport audit substrat.

25. Article émetteur de lumière de la revendication 24, dans lequel la lumière émise à travers ladite pluralité d'ouvertures converge en un point focal commun.

26. Article émetteur de lumière de la revendication 1, dans lequel
la portion haute de ladite structure réflectrice de lumière est immédiatement adjacente audit substrat de telle sorte que la lumière émise par ledit dispositif émetteur de lumière organique soit dirigée à l'écart dudit substrat.

27. Article émetteur de lumière de la revendication 26, dans lequel
ladite structure réflectrice de lumière est un creux dans la surface haute dudit substrat ; et la portion basse de ladite structure réflectrice de lumière est au ras de la surface haute dudit substrat.

28. Article émetteur de lumière de la revendication 26, comprenant en outre au moins une structure définissant un creux sur ledit substrat.

29. Article émetteur de lumière de la revendication 28, dans lequel ladite structure émettrice de lumière est un creux formé par au moins une dite structure définissant un creux.
